**Europäisches Patentamt**

**European Patent Office**

**Office européen des brevets**

(19)

(11) Veröffentlichungsnummer: **0 148 330**
**B1**

(12) **EUROPÄISCHE PATENTSCHRIFT**

(45) Veröffentlichungstag der Patentschrift:
02.09.87

(21) Anmeldenummer: **84111918.3**

(22) Anmeldetag: **04.10.84**

(51) Int. Cl.⁴: **H 01 L 43/06**

(54) **Integrierbares Hallelement.**

(30) Priorität: **19.12.83 CH 6739/83**

(43) Veröffentlichungstag der Anmeldung:
**17.07.85 Patentblatt 85/29**

(45) Bekanntmachung des Hinweises auf die Patenterteilung:
**02.09.87 Patentblatt 87/36**

(84) Benannte Vertragsstaaten:
**AT DE FR GB IT NL SE**

(56) Entgegenhaltungen:
**FR-A-2 412 949**

(73) Patentinhaber: **LGZ LANDIS & GYR ZUG AG, CH-6301 Zug (CH)**

(72) Erfinder: **Popovic, Radivoje, Fridbach 1, CH- 6300 Zug (CH)**

(74) Vertreter: **Müller, Hans- Jürgen, Dipl.- Ing., Müller, Schupfner & Gauger Lucile- Grahn- Strasse 38 Postfach 80 13 69, D-8000 München 80 (DE)**

## Beschreibung

### Anwendungsgebiet und Zweck

Die Erfindung bezieht sich auf ein integrierbares Hallelement gemäss dem Oberbegriff des Anspruchs 1.

Das Hallelement kann als Magnetfeldsensor z. B. in einem Elektrizitätszähler oder in einem Leistungsmesser zum Messen des verbrauchten Stromes verwendet werden, der ja bekanntlich proportional dem vom Strom erzeugten Magnetfeld ist.

### Stand der Technik

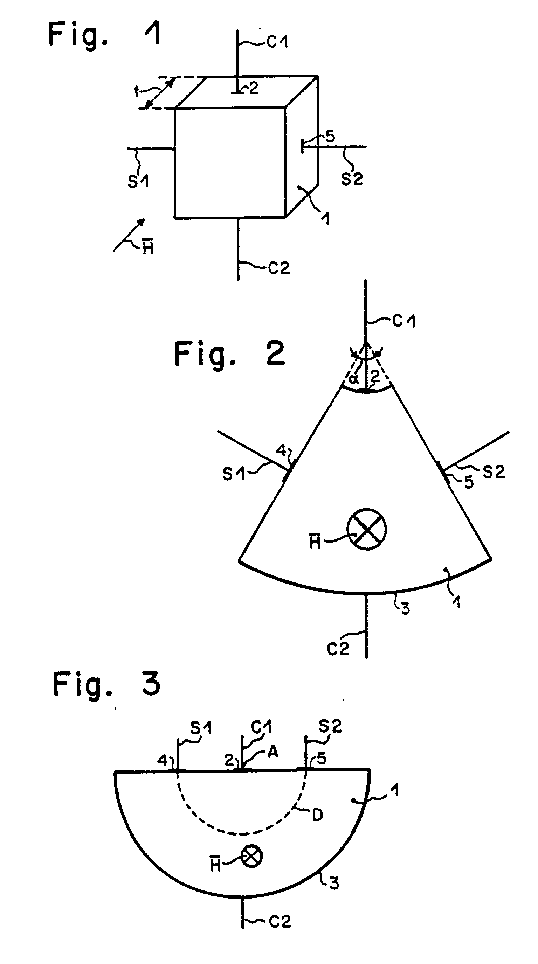

Aus der US-PS 4 253 107 ist ein integriertes Hallelement bekannt, das ein senkrecht zu seiner Oberfläche wirkendes Magnetfeld misst (Spalte 1, Zeilen 14 bis 20 und Fig. 2).

Weiterhin sind integrierte Magnetfeldsensoren bekannt, wie z. B. Magnetodioden und Magnetotransistoren, die ein parallel zu ihrer Oberfläche wirkendes Magnetfeld messen. Ihr Aufbau ist komplizierter als derjenige von Hallelementen. Sie sind ausserdem eher temperaturempfindlich und besitzen im Prinzip eine nichtlineare Kennlinie. Sie sind zusätzlich empfindlich gegenüber "Shot"-Rauschen. Ein derartiger Magnetotransistor ist z. B. bekannt aus IEEE Electron Device Letters, Vol. EDL-4, No. 3, März 83, Seiten 51 bis 53, "An investigation of the sensitivity of lateral magnetotransistors", R.S. Popovic et al.

### Aufgabe und Lösung

Der Erfindung liegt die Aufgabe zugrunde, einen Magnetfeldsensor zum Messen eines parallel zu seiner Oberfläche wirkenden Magnetfeldes zu realisieren, der Teil einer gebräuchlichen integrierten Schaltung in Standard-Bipolar- oder in Standard-CMOS-Technologie sein kann, eine Empfindlichkeit in der Grössenordnung von mindestens 1 Volt/(mA.Tesla) besitzt statt bisher annähernd 200mV/ (mA.Tesla), gemäss dem Halleffekt-Prinzip arbeitet und somit ein einfaches unipolares Bauelement mit allen dessen Vorteilen ist.

Die genannte Aufgabe wird erfindungsgemäss durch die im Kennzeichen des Anspruchs 1 angegebenen Merkmale gelöst.

Ein Ausführungsbeispiel der Erfindung ist in der Zeichnung dargestellt und wird im folgenden näher beschrieben.

Es zeigen: Fig. 1 ein bekanntes Hallelement,

Fig. 2 einen Querschnitt eines abgewandelten Hallelementes,

Fig. 3 einen Querschnitt eines weiteren abgewandelten Hallelementes,

Fig. 4 einen Querschnitt eines Hallelementes gemäss Fig. 3, das in einer Halbleiterschicht einer integrierten Schaltung eingebaut ist,

Fig. 5 eine schematische Darstellung der Stromverteilung in einem Querschnitt eines Hallelementes mit einer zylinderförmigen Stromelektrode,

Fig. 6 eine schematische Darstellung der Stromverteilung in einer Draufsicht des Hallelementes nach Fig. 5

Fig. 7 eine schematische Darstellung der Stromverteilung in einem Querschnitt eines Hallelementes mit einer hemisphärischen Stromelektrode,

Fig. 8 eine schematische Darstellung der Stromverteilung in einer Draufsicht des Hallelementes nach Fig. 7,

Fig. 9 eine Draufsicht einer annähernd achsensymmetrisch zu einer Geraden angeordneten Stromelektrode,

Fig. 10 eine Draufsicht einer annähernd symmetrisch zu einer ebenen Fläche angeordneten Stromelektrode,

Fig. 11 einen Querschnitt eines integrierbaren Hallelementes mit verteilten annähernd punktförmigen Stromelektroden,

Fig. 12 eine schematische Darstellung der Stromverteilung in einem Querschnitt des Hallelementes nach Fig. 11,

Fig. 13 eine schematische Darstellung der Stromverteilung in einer Draufsicht des Hallelementes nach Fig.11,

Fig. 14 eine Hälfte eines integrierbaren Hallelementes in CMOS-Technologie,

Fig. 15 eine schematische Darstellung der Stromverteilung in einem Querschnitt des Hallelementes nach Fig. 14 bei Nichtvorhandensein einer Equipotential-Diffusionsschicht,

Fig. 16 eine schematische Darstellung der Stromverteilung in einer Draufsicht des Hallelementes nach Fig. 15,

Fig. 17 eine schematische Darstellung der Stromverteilung in einem Querschnitt des Hallelementes nach Fig. 14 bei Nichtvorhandensein einer Isolationsschicht und bei Nichtvorhandensein verteilter punktförmiger Stromelektroden,

Fig. 18 eine schematische Darstellung der Stromverteilung in einer Draufsicht des Hallelementes nach Fig.17,

Fig. 19 eine schematische Darstellung der Stromverteilung in einem Querschnitt des Hallelementes nach Fig. 14 bei Nichtvorhandensein der verteilten punktförmigen Stromelektroden,

Fig. 20 eine schematische Darstellung der Stromverteilung in einer Draufsicht des Hallelementes nach Fig. 19

**0 148 330**

Fig. 21 eine Beschaltung eines in der Fig. 14 dargestellten integrierbaren Hallelementes,

Fig. 22 eine Hälfte eine integrierbaren Hallelementes in Bipolar-Technologie,

Fig. 23 eine schematische Darstellung der Stromverteilung in einem Querschnitt des Hallelementes nach Fig. 22 bei Nichtvorhandensein verteilter punktförmiger Stromelektroden und Fig. 24 eine schematische Darstellung der Stromverteilung in einer Draufsicht des Hallelementes nach Fig. 23.

Gleiche Bezugszahlen bezeichnen in allen Figuren der Zeichnung gleiche Teile.

**Beschreibung**

Das bekannte Hallelement der Fig. 1 besteht aus einem Halbleiterkristall 1 in Gestalt eines rechtwinkligen Parallelepipeds, dessen gegenüberliegende Seiten je ein Seiten paar bilden. Die Seiten eines ersten Seitenpaares besitzen je einen Stromanschluss C1 bzw. C2 und diejenigen eines zweiten Seitenpaares je einen Sensoranschluss S1 bzw. S2. Ein zu messendes Magnetfeld $\vec{H}$ ist parallel zur Dicke des Hallelementes und damit senkrecht zu dem dritten Seitenpaar angeordnet. Die Dicke des Hallelementes besitzt einen Wert t. Es gilt die Annahme, dass sich alle Anschlusspunkte der Stromanschlüsse C1 und C2 sowie der Sensoranschlüsse S1 und S2 in einer gemeinsamen Ebene befinden.

Nachfölgend wird angenommen, dass die Anschlusspunkte der Strom- und der Sensoranschlüsse C1, C2, S1 und S2 nicht nur punkt-, sondern auch flächenförmig sein können. Sie werden daher ganz allgemein als Strom- bzw. Sensorelektroden und die jeweiligen Verbindungspunkte mit dem zugehörigen Strom- bzw. Sensoranschluss C1, C2, S1 oder S2 als Anschlusskontakte bezeichnet.

Ein Hallelement besitzt somit eine mit dem ersten Stromanschluss C1 und einem ersten Strom-Anschlusskontakt versehene erste Stromelektrode 2, eine mit dem zweiten Stromanschluss C2 und einem zweiten Strom-Anschlusskontakt versehene zweite Stromelektrode 3, eine den ersten Sensoranschluss S1 und einen ersten Sensor-Anschlusskontakt besitzende erste Sensorelektrode 4 und eine den zweiten Sensoranschluss S2 und einen zweiten Sensor-Anschlusskontakt besitzende zweite Sensorelektrode 5.

Die Stromelektroden 2 und 3 dienen dem Anschluss einer Speisequelle, wobei der erste Strom-Anschlusskontakt einen ersten Speisepol bildet. Der zweite Strom-Anschlusskontakt und möglicherweise weitere Strom-Anschlusskontakte sind mindestens über eine elektrisch mehr oder weniger gut leitende Verbindung mit einem zweiten Speisepol verbunden.

Die Anschlusskontakte brauchen nicht im Zentrum der betreffenden Elektrodenflächen zu liegen.

Nachfolgend gilt die Annahme, dass die Flächen der ersten Stromelektrode 2 und der beiden Sensorelektroden 4 und 5 sehr klein sind und in erster Annäherung als punktförmige auf ihrem jeweiligen Zentrum liegend angenommen werden können, und dass in den Figuren 2 bis 3 die zweite Stromelektrode 3 die ganze Fläche der zugehörigen Seite des Hallelementes bedeckt.

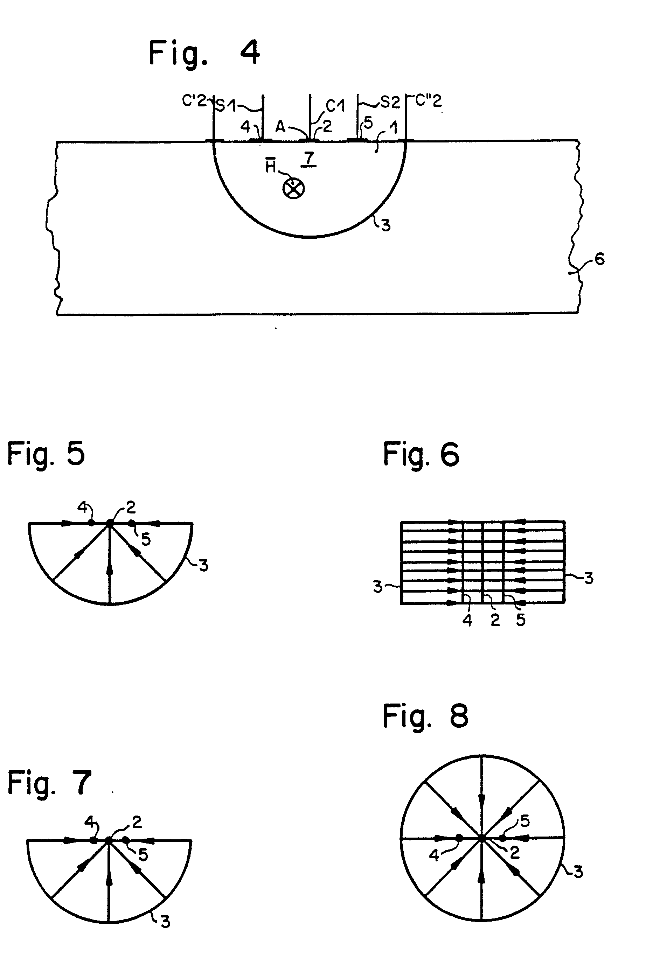

Das abgewandelte Hallelement der Fig. 2 entspricht annähernd dem Hallelement der Fig. 1, nur dass hier die Seiten des dritten Seitenpaares die Gestalt je eines Kreisringsektor besitzen, so dass im dargestellten Querschnitt die Seiten des ersten Seiten paares die Gestalt konzentrischer Kreisbögen haben und die Seiten des zweiten Seitenpaares nicht mehr parallel, sondern im dargestellten Querschnitt Kreisringradien sind, die einen Zentriwinkel α miteinander bilden. Das zu messende Magnetfeld $\vec{H}$ wirkt sowohl in der Fig. 2 als auch in den nachfolgenden Figuren 3 und 4 senkrecht zur Papierebene, z. B. von vorne nach hinten.

Das weitere abgewandelte Hallelement der Fig. 3 entspricht dem Hallelement der Fig. 2, in dem der Zentriwinkel α einen Wert von 180° besitzt, so dass der dargestellte Querschnitt die Gestalt eines Halbkreises hat. Der Querschnitt derjenigen Seite des ersten Seitenpaares, die den Stromanschluss C1 besitzt, reduziert sich dann auf den Zentrumspunkt A des Halbkreises.

In der Fig. 4 befindet sich das in der Fig. 3 dargestellte abgewandelte Hallelement an der Oberfläche in einer Halbleiterschicht 6 eines einzigen Leitfähigkeitstyps P oder N, und zwar dermassen angeordnet, dass der Durchmesser des Halbkreises, der die annähernd punktförmigen Sensorelektroden 4 und 5 sowie die annähernd punktförmige erste Stromelektrode 2 enthält, sich an der Oberfläche der Halbleiterschicht 6 befindet.

In den Figuren 2 und 3 besitzt die flächenhafte zweite Stromelektrode 3 einen einzigen, annähernd in der Mitte ihrer Fläche gelegenen Strom-Anschlusskontakt für den zweiten Stromanschluss C2. Die zweite Stromelektrode 3 kann jedoch auch mehrere Strom-Anschlusskontakte besitzen. Wird das Hallelement in einer integrierten Schaltung eingesetzt, so ist es vorteilhaft, diese Strom-Anschlusskontakte der zweiten Stromelektrode 3 wie in der Fig. 4 dargestellt unmittelbar an der Oberfläche der Halbleiterschicht 6 der integrierten Schaltung anzuordnen. In diesem Fall liegen dann alle Anschlusskontakte des Hallelementes an der Oberfläche der integrierten Schaltung. In der Fig. 4 wurde das Vorhandensein von nur zwei Strom-Anschlusskontakten der zweiten Stromelektrode 3 angenommen, die je einen Stromanschluss C'2 bzw. C''2 besitzen.

Die erste Stromelektrode 2 liegt, wie in den Figuren 3 und 4 dargestellt, wenigstens annähernd in der Mitte zwischen den Sensorelektroden 4 und 5 und wenigstens annähernd auf deren Verbindungsgeraden. Der Teil der Halbleiterschicht 6, der unterhalb der ersten Stromelektrode 2 und der beiden Sensorelektroden 4 und 5 liegt, bildet den aktiven Teil 7 des Hallelements.

Die Fläche der zweiten Stromelektrode 3 hat in den Figuren 3 und 4 eine an sich relativ ideale

3

zylinderförmige Gestalt mit halbkreisförmigem Querschnitt. Unter den Annahmen, dass die erste Stromelektrode 2 eine in der Oberflächenebene sehr kurze längliche Form senkrecht zum halbkreisförmigen Querschnitt besitzt, dass die Höhe der zylinderförmigen Gestalt der zweiten Stromelektrode 3 gleich gross ist wie die Länge der ersten Stromelektrode 2, und dass im Betrieb die elektrischen Ströme von der zweiten Stromelektrode 3 zur ersten Stromelektrode 2 fliessen, ist die Verteilung der Ströme innerhalb des Hallelementes aus den Figuren 5 und 6 ersichtlich. Im Querschnitt fliessen alle Ströme gemäss der Fig. 5 symmetrisch radial von der zylinderförmigen zweiten Stromelektrode 3 zur ersten Stromelektrode 2. In der Draufsicht fliessen dagegen alle Ströme gemäss der Fig. 6 in einer dünnen Scheibe senkrecht zur ersten Stromelektrode 2. In diesem Fall besitzen die beiden Sensorelektroden 4 und 5 ebenfalls vorzugsweise je eine parallele längliche und gleich lange Gestalt wie die erste Stromelektrode 2.

Die in der Fig. 7 dargestellte Stromverteilung im Querschnitt des Hallelementes mit einer hemispärischen zweiten Stromelektrode 3 ist identisch mit der in der Fig. 5 dargestellten Stromverteilung; die dazugehörige, in der Fig. 8 dargestellte Stromverteilung in der Draufsicht ist jedoch diesmal symmetrisch radial, d.h. alle Ströme fliessen in der Draufsicht der Fig. 8 radial von der zweiten Stromelektrode 3 zur ersten Stromelektrode 2.

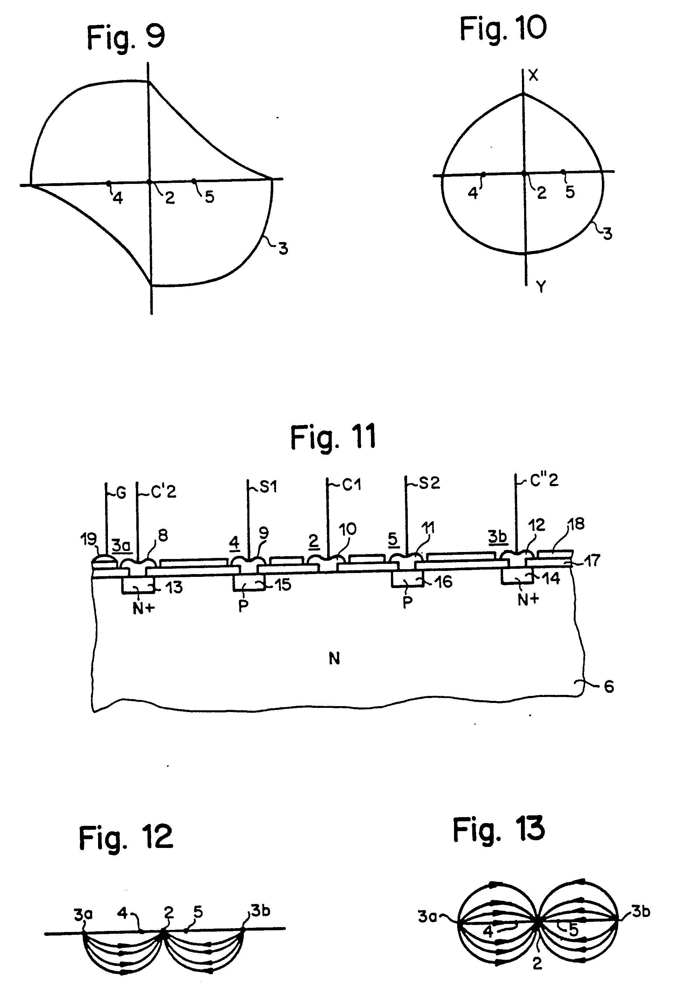

Die in der Fig. 9 dargestellte zweite Stromelektrode 3 ist annähernd achsensymmetrisch zu einer Geraden angeordnet, die durch die als annähernd punktförmig angenommene erste Stromelektrode 2 senkrecht zur Oberfläche der Halbleiterschicht 6 verläuft, d.h. die in der Fig. 9 dargestellte Draufsicht der zweiten Stromelektrode 3 ist punktsymmetrisch zur ersten Stromelektrode 2 angeordnet.

Die in der Fig. 10 dargestellte zweite Stromelektrode 3 ist annähernd symmetrisch zu einer ebenen Fläche angeordnet, die durch die erste Stromelektrode 2 senkrecht zur Verbindungsgeraden der ebenfalls annähernd als punktförmig angenommenen Sensorelektroden 4 und 5 verläuft, d.h. die in der Fig. 10 dargestellte Draufsicht der zweiten Stromelektrode 3 ist achsensymmetrisch zu einer Geraden XY angeordnet, die durch die erste Stromelektrode 2 senkrecht zur Verbindungsgeraden der Sensorelektroden 4 und 5 verläuft.

Die Strom-Anschlusskontakte des integrierbaren Hallelementes können teilweise Schottkydioden-Kontakte oder alle ohmische Kontakte sein. Die Sensor-Anschlusskontakte können dagegen zusätzlich noch normale P/N-Dioden-Kontakte sein.

In der Fig. 11 sind als Beispiel die Strom-Anschlusskontakte der Stromanschlüsse C'2 und C''2 als ohmische Kontakte, der Strom-Anschlusskontakt des ersten Stromanschlusses C1 als Schottkydioden-Kontakt und die Sensor-Anschlusskontakte der Sensoranschlüsse S1 und S2 als P/N-Dioden-Kontakte ausgebildet. Das in der Fig. 11 dargestellte integrierbare Hallelement entspricht annähernd dem in der Fig. 4 dargestellten Hallelement, nur dass hier die flächenhafte zweite Stromelektrode 3 auf zwei verteilte annähernd punktförmige Stromelektroden 3a und 3b reduziert wurde, die räumlich dort angeordnet sind, wo sich die beiden Strom-Anschlusskontakte der Stromanschlüsse C'2 und C''2 befinden. Das in der Fig. 11 dargestellte Hallelement besteht somit aus der Halbleiterschicht 6 eines bestimmten Leitfähigkeitstyps, z. B. des Typs N, an dessen Oberfläche fünf metallische Anschlusskontakte 8, 9, 10, 11 und 12 der Strom- bzw. Sensoranschlüsse C'2, S1, C1, S2 und C''2 vorhanden sind. Unterhalb der beiden äusseren metallischen Anschlusskontakte 8 und 12 und in einem intimen Kontakt mit denselben befindet sich in der Halbleiterschicht 6 an deren Oberfläche je ein Diffusions-Kontakt 13 bzw. 14, der vom gleichen Leitfähigkeitstyp ist wie das Halbleitermaterial, in das sie eindiffundiert sind, und stark mit Fremdatomen dotiert ist. Die Kontakt-Kombinationen 8;13 und 12;14 stellen ohmische Kontakte dar und bilden je eine verteilte annähernd punktförmige zweite Stromelektrode 3a bzw. 3b mit den Stromanschlüssen C'2 oder C''2. Der zentrale metallische Anschlusskontakt 10 besitzt keinen Diffusions-Kontakt, stellt daher einen Schottkydioden-Kontakt dar und bildet die erste Stromelektrode 2 mit dem ersten Stromanschluss C1. Unterhalb der beiden verbleibenden metallischen Anschlusskontakte 9 und 11 befindet sich in der Halbleiterschicht 6 an deren Oberfläche je ein Diffusions-Kontakt 15 bzw. 16, der vom entgegengesetzten Leitfähigkeitstyp ist als die Halbleiterschicht 6. Die Kontakt-Kombinationen 9;15 und 11;16 stellen P/N-Dioden-Kontakte dar und bilden je eine Sensorelektrode 4 bzw. 5 mit dem jeweiligen Sensoranschluss S1 oder S2. Die Oberfläche der Halbleiterschicht 6 ist vollständig mit einer dünnen elektrisch isolierenden Passivationsschicht 17, z. B. aus $SiO_2$, bedeckt, die ihrerseits fakultativ vollständig mit einem elektrisch gut leitenden "Gate" 18 aus Metall oder aus Polysilicon bedeckt ist, wobei die Passivationsschicht 17 und das "Gate" 18 Durchführungen für die Anschlusskontakte besitzen. Das "Gate" 18 weist einen Anschlusskontakt 19 auf für den Gateanschluss G. Das "Gate" 18 und die metallischen Anschlusskontakte 8 bis 12 sind elektrisch voneinander isoliert. Über den Gateanschluss G wird am Anschlusskontakt 19 des "Gate" 18 eine elektrische Spannung angelegt, die dazu dienen kann, die Empfindlichkeit des Hallelementes zu steuern.

Die Stromverteilung innerhalb des in der Fig. 11 dargestellten Hallelementes ist im Querschnitt in der Fig. 12 und in der Draufsicht in der Fig. 13 wiedergegeben. Die elektrischen Ströme fliessen sowohl in diesem Querschnitt als auch in dieser Draufsicht von den beiden annähernd punktförmigen Stromelektroden 3a und 3b ausgehend bogenförmig auseinander, um sich anschliessend wieder bogenförmig zu konzentrieren und zur ersten Stromelektrode 2 zu fliessen.

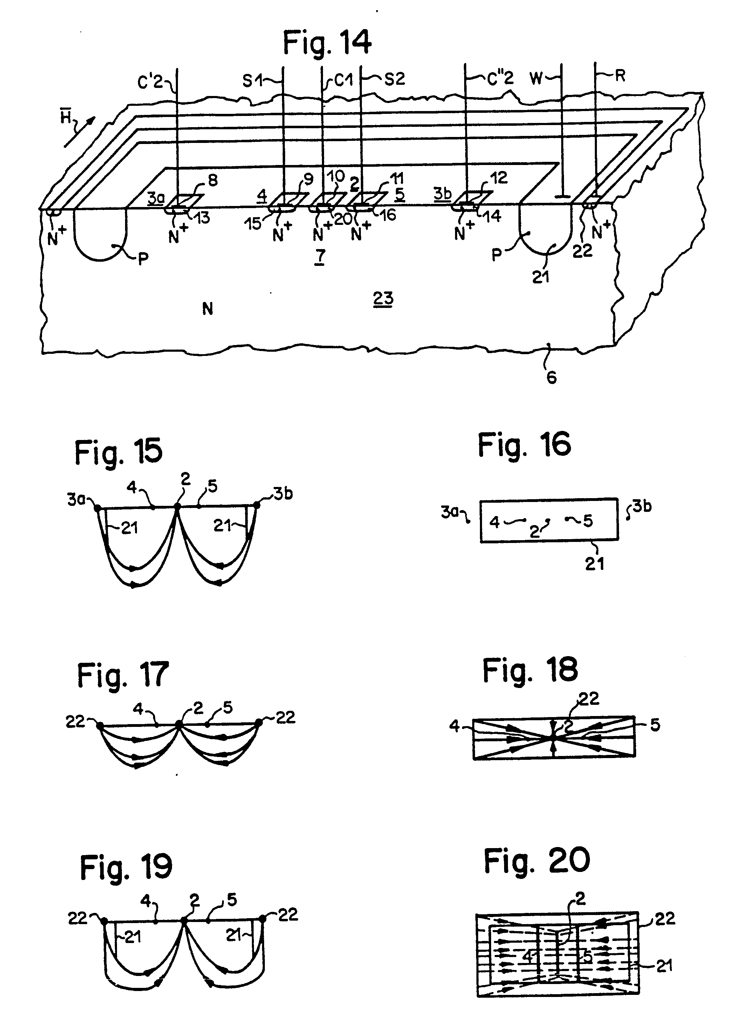

Das in der Fig. 14 dargestellte Hallelement entspricht annähernd dem in der Fig. 11 dargestellten Hallelement, nur dass hier die Passivationsschicht 17 und das "Gate" 18 weggelassen wurde, alle Anschlusskontakte nur schematisch dargestellt und als rein ohmische Kontakte ausgebildet sind, und somit der zentrale metallische Anschlusskontakt 10 ebenfalls einen Diffusions-Kontakt besitzt. Alle fünf Diffusions-Kontakte 13, 15, 20, 16 und 14 sind in der Fig. 14 stark mit Fremdatomen dotiert und haben alle den gleichen Leitfähigkeitstyp wie die Halbleiterschicht 6. Das in der Fig. 14 dargestellte Hallelement ist zusätzlich noch seitlich ringartig vollständig von einer an der Oberfläche in die Halbleiterschicht 6 eindiffundierten tiefen

länglich-ringförmigen Isolationsschicht 21 umgeben, die z. B. aus Material vom entgegengesetzten Leitfähigkeitstyp besteht wie die Halbleiterschicht 6, in unserem Beispiel also vom Typ P ist, und an einer beliebigen Stelle einen Anschlusskontakt mit einem Drahtanschluss W besitzt. Die Isolationsschicht 21 umgibt in der Praxis immer mindestens die erste Stromelektrode 2, d.h. hier die Kontakt-Kombination 10;20, und die beiden Sensorelektroden 4 und 5, d.h. hier die Kontakt-Kombinationen 9;15 und 11;16. Das Zentrum der länglich-ringförmigen Isolationsschicht 21 wird annähernd von der ersten Stromelektrode 2 gebildet. Ihre Längsachse verläuft annähernd parallel zur Verbindungsgeraden der Sensorelektroden 4 und 5. Ihre Tiefe ist bedeutend grösser als die Tiefe der Kontaktregion der Anschlusskontakte. Die Isolationsschicht 21 ist achsensymmetrisch zu der Geraden angeordnet, die durch die erste Stromelektrode 2 senkrecht zur Oberfläche der Halbleiterschicht 6 verläuft, oder symmetrisch zu der ebenen Fläche angeordnet, die durch die erste Stromelektrode 2 senkrecht zur Verbindungsgeraden der Sensorelektroden 4 und 5 verläuft. Die Isolationsschicht 21 ist ihrerseits in der Fig. 14 noch zusätzlich in einem Abstand von einer durchgehenden ringförmigen, dünnen, stark mit Fremdatomen dotierten und elektrisch gut leitenden Equipotential-Diffusionsschicht 22 umgeben, die aus Material vom gleichen Leifähigkeitstyp besteht wie die Halbleiterschicht 6 und ebenfalls an beliebiger Stelle einen Anschlusskontakt mit einem diesmal mit R bezeichneten Drahtanschluss besitzt. Die Halbleiterschicht 6 ist in der CMOS-Technologie entweder ein N-Substrat oder eine N-Wanne, die in einem schwach mit Fremdatomen dotierten Substrat vom entgegengesetzten Leitfähigkeitstyp eindiffundiert ist. Die beiden annähernd punktförmigen Kontakt-Kombinationen 8;13 und 12;14 sowie die Equipotential-Diffusionsschicht 22 sind verteilte Stromelektroden, die zusammen die zweite Stromelektrode 3 bilden. In der Praxis können auch nur die beiden Kontakt-Kombinationen 8;13 und 12;14 oder auch nur die Equipotential-Diffusionsschicht 22 als zweite Stromelektrode 3 vorhanden sein. Die Equipotential-Diffusionsschicht 22 bildet eine durchgehende Fläche und liegt in der Oberflächenebene der Halbleiterschicht 6. Sie umgibt voll oder teilweise ringförmig auf jeden Fall mindestens die erste Stromelektrode 2 und die beiden Sensorelektroden 4 und 5, wobei die erste Stromelektrode 2 mindestens annähernd im Zentrum der ringförmigen Fläche liegt.

Die Stromverteilung innerhalb des in der Fig. 14 dargestellten Hallelementes, jedoch ohne die Equipotential-Diffusionsschicht 22, ist im Querschnitt in der Fig. 15 und in der Draufsicht in der Fig. 16 wiedergegeben. Es wurde dabei angenommen, dass die verteilten punktförmigen Stromelektroden 3a und 3b im Gegensatz zur Darstellung der Fig. 14 ausserhalb der Isolationsschicht 21 liegen. Die elektrische Ströme fliessen im Querschnitt der Fig. 15 von den beiden Stromelektroden 3a und 3b ausgehend tief nach unten um die tiefe Isolationsschicht 21 herum und erreichen die erste Stromelektrode 2 fast senkrecht von unten kommend. In der Draufsicht der Fig. 16 fliessen keine Oberflächenströme, da diese durch die Isolationsschicht 21 verhindert werden.

Die Stromverteilung innerhalb des in der Fig. 14 dargestellten Hallelementes bei Nichtvorhandensein der Isoaltionsschicht 21 und beim Nichtvorhandensein der verteilten punktförmigen Stromelektroden 3a und 3b ist im Querschnitt in der Fig. 17 und in der Draufsicht in der Fig. 18 wiedergegeben. Im Querschnitt ist die Stromverteilung ähnlich wie in der Fig. 12 und in der Draufsicht fliessen dagegen alle Ströme symmetrisch radial von der als rechteckringförmig angenommenen Equipotential-Diffusionsschicht 22 zur ersten Stromelektrode 2.

Die Stromverteilung innerhalb des in der Fig. 14 dargestellten Hallelementes bei Nichtvorhandensein der verteilten punktförmigen Stromelektroden 3a und 3b ist im Querschnitt in der Fig. 19 und in der Draufsicht in der Fig. 20 wiedergegeben. Die Stromverteilung im Querschnitt der Fig. 19 ist ähnlich wie diejenige in der Fig. 15. Wenn die Länge der ersten Stromelektrode 2 annähernd ebenso gross ist wie die sehr kleine Breite der länglichringförmigen Equipotential-Diffusionsschicht 22, und parallel zu dieser Breite angeordnet ist, so fliessen in der Draufsicht der Fig. 20 alle Ströme tief unten in der Halbleiterschicht 6, daher gestrichelt dargestellt, mehr oder weniger parallel zur Längsachse der Equipotential-Diffusionsschicht 22 und zwar jeweils von dieser ausgehend zur ersten Stromelektrode 2 hinfliessend. In diesem Fall besitzen die beiden Sensorelektroden 4 und 5 vorzugsweise ebenfalls je eine parallele längliche und gleiche lange Gestalt wie die erste Stromelektrode 2.

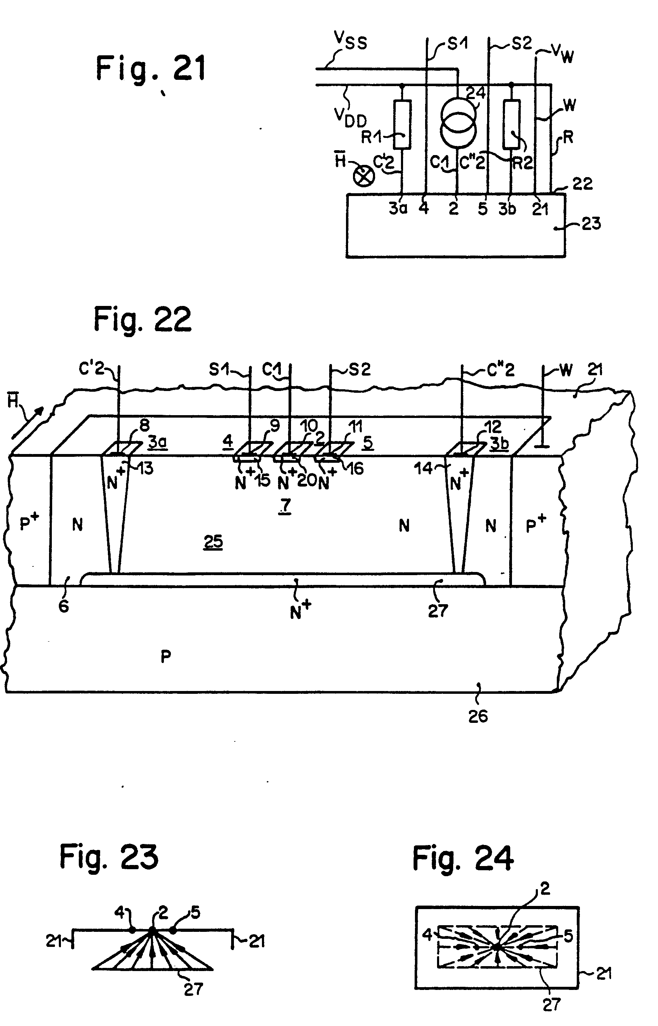

Das Hallelement 23 der Fig. 14 ist wie in der Fig. 21 dargestellt zu beschalten. Das heisst, die zentrale erste Stromelektrode 2 ist extern mit einem Pol einer Stromquelle 24 verbunden, wobei deren anderer Pol an einem zum Beispiel negativen Pol $V_{SS}$ einer Speisespannung liegt, während die Equipotential-Diffusionsschicht 22 direkt und die beiden verteilten punktförmigen Stromelektroden 3a und 3b über je einen Widerstand R1 bzw. R2 mit dem anderen Pol $V_{DD}$ der Speisespannung verbunden sind. Die Isolationsschicht 21 liegt an einer elektrischen Spannung $V_W$, die so gewählt ist, dass im Betrieb der P/N-Übergang der Halbleiterschicht 6 zur Isolationsschicht 21 in Sperrrichtung gepolt ist, und somit hier negativer ist als die Spannung $V_{C1}$ an der ersten Stromelektrode 2. Die Spannung $V_W$ der Isolationsschicht 21 kann dazu dienen, die Empfindlichkeit des Hallelementes 23 zu steuern. Wenn die Halbleiterschicht 6 aus Si besteht, kann die Isolationsschicht 21 aus $SiO_2$ hergestellt werden und benötigt dann keinen Drahtanschluss W.

Das integrierbare Hallelement 25 der Fig. 22 entspricht annähernd dem integrierbaren Hallelement 23 der Fig. 14, nur dass hier die Halbleiterschicht 6 als Epitaxie-Schicht auf einem Substrat 26 vom entgegengesetzten Leitfähigkeitstyp, also vom Typ P, aufgewachsen ist, dass keine Equipotential-Diffusionsschicht 22 existiert und die länglich-ringförmige Isolationsschicht 21 stark mit Fremdatomen dotiert und tief eindiffundiert ist bis zum Kontakt mit dem Substrat 26. Zusätzlich ist unterhalb des aktiven Teils 7 des Hallelementes 25 an der Grenze zwischen Substrat 26 und Halbleiterschicht 6 in der letzteren eine stark mit Fremdatomen dotierte elektrisch

5

gut leitende "'Buried layer"-Schicht 27 vom gleichen Leitfähigkeitsstyp wie die Halbleiterschicht 6 parallel zur Oberfläche der Halbleiterschicht 6 angeordnet. Ausserdem können die beiden verteilten annähernd punktförmigen Stromelektroden 3a und 3b fakultativ in der Tiefe verlängert sein bis hinunter zum Kontakt mit der "Buried layer"-Schicht 27. Diese bildet zusammen mit den beiden verteilten annähernd punktförmigen Stromelektroden 3a und 3b die zweite Stromelektrode 3, deren Anschlusskontakt, falls kein Kontakt zwischen den punktförmigen Stromelektroden 3a und 3b und der "Buried layer"-Schicht 27 besteht, elektrisch isoliert nicht dargestellt ausserhalb des aktiven Teils 7 des Hallelementes 25 an der Oberfläche der Halbleiterschicht 6 angeordnet und innerhalb dieser Halbleiterschicht 6 über eine elektrisch mehr oder weniger gut leitende ohmische Verbindung mit ihr verbunden ist.

Das integrierbare Hallelement 25 der Fig. 22 ist ähnlich zu beschalten wie das Hallelement 23 der Fig. 14, nur dass der Drahtanschluss R fehlt und der Anschluss W bei dem angegebenen Leitfähigkeitstyp P am negativen Pol $V_{SS}$ der Speisespannung liegt.

Die Stromverteilung innerhalb des in der Fig. 22 dargestellten Hallelementes bei Nichtvorhandensein der zwei verteilten punktförmigen Stromelektroden 3a und 3b ist im Querschnitt in der Fig. 23 und in der Draufsicht in der Fig. 24 wiedergegeben. Die Ströme fliessen im Querschnitt der Fig. 23 alle tief unten in der Halbleiterschicht 6 symmetrisch konzentrisch von der "Buried layer"-Schicht 27 ausgehend, die hier die Funktion der zweiten Stromelektrode 3 ausübt, zur punktförmigen ersten Stromelektrode 2. In der Draufsicht der Fig. 24 fliessen die Ströme ebenfalls alle tief unten in der Halbleiterschicht 6, daher gestrichelt dargestellt, symmetrisch konzentrisch von der "Buried Layer"-Schicht 27 ausgehend zur punktförmigen ersten Stromelektrode 2.

**Funktionsbeschreibung**

Fliesst in dem in der Fig. 1 dargestellten Hallelement ein Strom I durch die Stromanschlüsse C1, C2, so erscheint bekanntlich eine Hallspannung zwischen den Sensoranschlüssen S1 und S2. Wird nun dieses Hallelement deformiert, so dass es nacheinander die Gestalt gemäss Fig. 2 und gemäss Fig. 3 annimmt, so ändert sich die Arbeitsweise des Hallelementes prinzipiell nicht. Auch bleibt seine Empfindlichkeit annähernd gleich. Die Hallspannung zwischen den Sensoranschlüssen S1 und S2 des in der Fig. 3 dargestellten Hallelementes ist:

$$V^H_{S1-S2} = \int_{S1}^{S2} \vec{E}_H \cdot \vec{dl} \qquad (1),$$

wobei $\vec{E}_H$

das elektrische Hallfeld und $\vec{dl}$

eine Teilstrecke einer beliebigen Verbindungsstrecke zwischen den Sensoranschlüssen S1 und S2 ist. Wird als Integrationsweg der die Sensoranschlüsse S1 und S2 verbindende Halbkreis D gewählt (siehe Fig. 3), dessen Zentrum gleich dem Zentrumspunkt A ist, so ergibt die Gleichung (1) den Wert:

$$V^H_{S1-S2} = (R_H \cdot I \cdot B)/t \qquad (2),$$

wobei $R_H \cong 1/(q \cdot n)$, q die Elementarladung, n die Dichte der Majoritäts-Ladungsträger, t die Dicke des Hallelementes, I der Wert des Stromes zwischen den Stromanschlüssen C1 und C2 sowie $B = \mu H$ der Wert der Magnetinduktion des zu messenden Magnetfeldes $\vec{H}$ ist. Die Gleichung (2) ist genau gleich derjenigen Gleichung, die für das in der Fig. 1 dargestellte bekannte Hallelement gilt. Ein Vorteil des in der Fig. 3 dargestellten Hallelementes ist, dass es gemäss Fig. 4 in einer Halbleiterschicht einer elektrisch isolierten Insel einer integrierten Schaltung eingebaut werden kann.

Die zweite Stromelektrode 3 braucht nicht unbedingt die in der Fig. 4 angegebene Gestalt zu besitzen. Auch braucht sie nicht unbedingt eine durchgehende Fläche zu sein, sondern kann z. B. aus mehreren verteilten annähernd punktförmigen Stromelektroden bestehen, die einen Anschlusskontakt besitzen und die räumlich so angeordnet sind, dass alle im Betrieb fliessenden Ströme eine vektorielle Strom-Resultierende bilden, die mindestens in der Nähe der ersten Stromelektrode 2 im wesentlichen senkrecht zur Oberfläche der Halbleiterschicht 6 verläuft. Mindestens ein Teil der verteilten Stromelektroden ist z. B. zu diesem Zweck paarweise annähernd achsensymmetrisch zu einer Geraden angeordnet, die durch die erste Stromelektrode 2 senkrecht zur Oberfläche der Halbleiterschicht 6 verläuft. Mindestens ein Teil der restlichen nicht achsensymmetrisch angeordneten verteilten Stromelektroden ist dann zu diesem Zweck paarweise annähernd symmetrisch zu einer ebenen Fläche angeordnet, die durch die erste Stromelektrode 2 senkrecht zur Verbindungsgeraden der Sensorelektroden 4 und 5 verläuft. Auch können z. B. alle verteilte Stromelektroden paarweise symmetrisch zu der erwähnten Fläche sein.

Mindestens ein Teil der verteilten Stromelektroden können z. B. elektrisch gut leitende und durchgehende Teilflächen bilden, die ihrerseits paarweise gleich sind und ebenso symmetrisch angeordnet sind zu der betreffenden Geraden bzw. zu der betreffenden ebenen Fläche wie die verteilten punktförmigen Stromelektroden, aus denen sie zusammengesetzt sind. Alle Teilflächen sind z. B. parallel zur Oberfläche der Halbleiterschicht 6 angeordnet, oder parallele Teilflächen liegen alle in einer Ebene, oder sie bilden alle zusammen eine einzige durchgehende Fläche.

Die zweite Stromelektrode 3 besteht z. B. in der Fig. 4 aus einer einzigen zylinderförmigen durchgehenden symmetrischen Fläche, in der Fig. 9 aus einer einzigen achsensymmetrischen durchgehenden Fläche, in der Fig. 10 aus einer einzigen flächensymmetrischen durchgehenden Fläche, in der Fig. 11 aus nur zwei verteilten annähernd punktförmigen und symmetrisch angeordneten Stromelektroden 3a und 3b, in der Fig. 14 aus zwei verteilten annähernd punktförmigen und symmetrisch angeordneten Stromelektroden 3a und 3b und einer durchgehenden symmetrischen Equipotential-Diffusionsschicht 22, und in der Fig. 22 aus zwei verteilten annähernd punktförmigen und symmetrisch angeordneten Stromelektroden 3a und 3b und einer durchgehenden symmetrisch angeordneten und parallel zur Oberfläche liegenden "Buried layer"-Schicht 27.

Alle diese Anordnungen der zweiten Stromelektrode 3 führen dazu, wie dies aus den in den Figuren 5 bis 8, den Figuren 12 bis 13, den Figuren 15 bis 20 und den Figuren 23 bis 24 dargestellten Stromverteilungen ersichtlich ist, dass im Betrieb alle elektrische Ströme symmetrisch verteilt mehr oder weniger radial zwischen der ersten und der zweiten Stromelektrode 2 und 3 fliessen, so dass ihre vektorielle Strom-Resultierende in der Nähe der ersten Stromelektrode 2 im wesentlichen senkrecht zur Oberfläche der Halbleiterschicht 6 verläuft.

Alle verteilten Teilflächen oder punktförmigen Stromelektroden der zweiten Stromelektrode 3 müssen über eine elektrische mehr oder weniger gut leitende Verbindung mit mindestens einem Anschlusskontakt verbunden sein, der dann den zweiten Speisepol des Hallelementes bildet.

Die elektrisch gut leitenden durchgehenden Teilflächen und Flächen der zweiten Stromelektrode 3 bestehen z. B. aus Halbleitermaterial, das stark mit Fremdatomen dotiert und vom gleichen Leitfähigkeitstyp P oder N ist wie die Halbleiterschicht 6.

Die Halbleiterschicht 6 ist z. B. in der Bipolar-Technologie eine Epitaxieschicht, die auf einem Substrat aufgewachsen ist (siehe Fig. 22) oder in der CMOS-Technologie eine Wanne, die in einem Substrat eindiffundiert ist, wobei das Substrat vom entgegengesetzten Leitfähigkeitstyp ist wie die Halbleiterschicht 6. Diese besteht aus Si oder aus GaAs, wobei die Verwendung von GaAs eine höhere Empfindlichkeit des Hallelementes ergibt, und ist annähernd uniform mit Fremdatomen dotiert.

Der Teil der Halbleiterschicht 6, der beim in der Fig. 14 dargestellten Hallelement 23 unmittelbar ausserhalb des eigentlichen Hallelementes liegt, muss im Fall des Leitfähigkeitstyps N mit Hilfe der Equipotential-Diffusionsschicht 22 gemäss der Fig. 21 mit dem positiven Pol $V_{DD}$ der Speisespannung auf dem höchsten in der integrierten Schaltung vorkommenden elektrischen Potential verbunden werden, so dass jede Interferenz zwischen dem Hallelement 23 und dem Rest der intergrierten Schaltung vermieden wird. In der Fig. 22 übernimmt die Isolationsschicht 21 diese Aufgabe, das Hallelement 25 gegen über den Rest der integrierten Schaltung elektrisch zu isolieren.

Die Isolationsschicht 21 hat zusätzlich noch die Aufgabe im Betrieb in den beiden Figuren 14 und 22 die Stromverteilungen im aktiven Teil 7 des Hallelementes 23 bzw. 25 von einer eher radial-hemisphärischen in eine radial-zylindrische, wie z. B. in der Fig. 20 dargestellt, umzuwandeln, wobei die geringe Höhe der radialzylindrischen Stromverteilung dieser Stromverteilung ein scheibenhaftes Aussehen verleiht, was der Empfindlichkeit des Hallelementes 23 bzw. 25 zugute kommt.

Die Verwendung der in der Fig. 21 dargestellten Widerstände R1 und R2 ist fakultativ, und ihre Werte sind relativ klein, z. B. annähernd gleich 1 kΩ, zu wählen. Sie können zur Annullierung der Offset-Spannung verwendet werden.

Das "Gate" 18 des in der Fig. 11 dargestellten Hallelementes mit einer am Gateanschluss G anliegenden elektrischen Spannung stabilisiert die Oberflächeneigenschaften und damit auch die Kennlinien des Hallelementes, vermindert dessen Oberflächenrauschen und verbessert seine Empfindlichkeit.

Das integrierbare Hallelement dient der Messung einer parallel zu seiner Oberfläche wirkenden Magnetfeldkomponente bzw., bei entsprechender räumlicher Anordnung, eines parallel zu seiner Oberfläche wirkenden Magnetfeldes. Letzteres hat den Vorteil, dass das Magnetfeld in den parallel zur Oberfläche der integrierten Schaltung verlaufenden Strompfaden keine störende und das Messresultat verfälschende Spannungen induzieren kann. Das Hallelement ist z. B. ein Teil des Messwerkes eines Elektrizitätszählers und das Magnetfeld wird z. B. von einem zu messenden Strom erzeugt.

Die Verwendung einer Standard-Bipolar- oder einer Standard-CMOS-Technologie hat den Vorteil, dass eine gewünschte Änderung in den Eigenschaften des Hallelementes, z. B. eine Verbesserung von dessen Empfindlichkeit, keine Änderungen der Schichtdicken senkrecht zur Oberfläche des Hallelementes erforderlich macht, sondern nur eine Änderung der Schichtbreiten, d.h. eine Maskenänderung, nach sich zieht.

## Patentansprüche

1. Integrierbares Hallelement, das aus einer Halbleiterschicht (6) eines einzigen Leitfähigkeitstyps besteht, an deren Oberfläche zwei Sensorelektroden (4, 5) und mindestens eine erste von mehreren Stromelektroden (2) angeordnet sind, wobei die Stromelektroden dem Anschluss an eine Speisequelle dienen und die erste Stromelektrode einen ersten Anschlusskontakt besitzt, der einen ersten Speisepol bildet, dadurch gekennzeichnet, dass die erste Stromelektrode (2) annähernd in der Mitte zwischen den Sensorelektroden (4, 5) und annähernd auf deren Verbindungsgeraden liegt und verteilte Stromelektroden, die einen Anschlusskontakt besitzen, der den zweiten Speisepol bildet, so angeordnet sind, dass alle im Betrieb zwischen den Stromelektroden (2, 3) fliessenden Ströme eine vektorielle Strom-Resultierende bilden, die in der Nähe der ersten Stromelektrode (2) im wesentlichen senkrecht zur Oberfläche der Halbleiterschicht (6) verläuft.

2. Hallelement nach Anspruch 1, dadurch gekennzeichnet, dass mindestens ein Teil der verteilten Stromelektroden annähernd achsensymmetrisch zu einer Geraden angeordnet ist, die durch die erste Stromelektrode (2) senkrecht zur Oberfläche der Halbleiterschicht (6) verläuft.

3. Hallelement nach Anspruch 1 oder 2, dadurch gekennzeichnet, dass mindestens ein Teil der verteilten Stromelektroden annähernd symmetrisch zu einer ebenen Fläche angeordnet ist, die durch die erste Stromelektrode (2) senkrecht zur Verbindungsgeraden der Sensorelektroden (4, 5) verläuft.

4. Hallelement nach Anspruch 2, dadurch gekennzeichnet, dass alle restlichen verteilten Stromelektroden annähernd symmetrisch zu einer ebenen Fläche angeordnet sind, die durch die erste Stromelektrode (2) senkrecht zur Verbindungsgeraden der Sensorelektroden (4, 5) verläuft.

5. Hallelement nach Anspruch 2 oder 3, dadurch gekennzeichnet, dass mindestens zwei verteilte annähernd punktförmige Stromelektroden (3a, 3b) vorhanden sind, die über je einen Widerstand (R1, R2) mit einem Pol einer Speisespannung verbunden sind, wobei die Widerstände (R1, R2) der Annullierung einer Offset-Spannung dienen.

6. Hallelement nach einem der Ansprüche 2 bis 5, dadurch gekennzeichnet, dass mindestens ein Teil der verteilten Stromelektroden elektrisch gut leitende und durchgehende Teilflächen bildet, die ihrerseits paarweise gleich sind und ebenso symmetrisch angeordnet sind zu der betreffenden Geraden bzw. zu der betreffenden ebenen Fläche wie die verteilten Stromelektroden, aus denen sie zusammengesetzt sind.

7. Hallelement nach Anspruch 6, dadurch gekennzeichnet, dass alle Teilflächen parallel zur Oberfläche der Halbleiterschicht (6) angeordnet sind.

8. Hallelement nach Anspruch 7, dadurch gekennzeichnet, dass alle parallelen Teilflächen in eine Ebene liegen.

9. Hallelement nach Anspruch 8, dadurch gekennzeichnet, dass alle Teilflächen eine einzige durchgehende Fläche bilden.

10. Hallelement nach Anspruch 9, dadurch gekennzeichnet, dass die durchgehende Fläche in der Halbleiterschicht (6) unterhalb des aktiven Teils (7) des Hallelementes parallel zur dessen Oberfläche liegt, und dass ihr Anschlusskontakt elektrisch isoliert ausserhalb des aktiven Teils (7) an der Oberfläche der Halbleiterschicht (6) angeordnet ist und innerhalb der Halbleiterschicht (6) über eine elektrische ohmische Verbindung mit ihr verbunden ist.

11. Hallelement nach Anspruch 9, dadurch gekennzeichnet, dass die durchgehende Fläche in Gestalt einer Equipotential-Diffusionsschicht (22) in der Oberflächenebene der Halbleiterschicht (6) liegt und dass sie die erste Stromelektrode (2) und die Sensorelektroden (4, 5) ringförmig umgibt, wobei die erste Stromelektrode (2) mindestens annähernd im Zentrum der ringförmigen Fläche liegt.

12. Hallelement nach einem der Ansprüche 6 bis 11, dadurch gekennzeichnet, dass die elektrisch gut leitenden und durchgehenden Teilflächen aus Halbleitermaterial bestehen, das stark mit Fremdatomen dotiert und vom gleichen Leitfähigkeitstyp ist wie die Halbleiterschicht (6).

13. Hallelement nach einem der Ansprüche 1 bis 12, dadurch gekennzeichnet, dass eine an der Oberfläche in die Halbleiterschicht (6) eindiffundierte tiefe länglich-ringförmige Isolationsschicht (21) vorhanden ist, die mindestens die erste Stromelektrode (2) und die Sensorelektroden (4, 5) umgibt, wobei ihr Zentrum annähernd von der ersten Stromelektrode (2) gebildet wird, ihre Längsachse annähernd parallel zur Verbindungsgeraden der Sensorelektroden (4, 5) verläuft, ihre Tiefe bedeutend grösser ist als die Tiefe der Kontaktregion der Anschlusskontakte und die Isolationsschicht (21) achsensymmetrisch zu einer Geraden ist, die durch die erste Stromelektrode (2) senkrecht zur Oberfläche der Halbleiterschicht (6) verläuft, oder die Isolationsschicht symmetrisch zu einer ebenen Fläche ist, die durch die erste Stromelektrode (2) senkrecht zur Verbindungsgeraden der Sensorelektroden (4, 5) verläuft.

14. Hallelement nach Anspruch 11 oder 12, dadurch gekennzeichnet, dass eine an der Oberfläche in die Halbleiterschicht (6) eindiffundierte tiefe länglich-ringförmige Isolationsschicht (21) vorhanden ist, die mindestens die erste Stromelektrode (2) und die Sensorelektroden (4, 5) umgibt und ihrerseits durch eine durchgehende ringförmige Fläche in Gestalt einer Equipotential-Diffusionsschicht (22) umgeben ist, wobei ihr Zentrum annähernd von der ersten Stromelektrode (2) gebildet wird, ihre Längsachse annähernd parallel zur Verbindungsgeraden der Sensorelektroden (4, 5) verläuft, die Tiefe der Isolationsschicht bedeutend grösser ist als die Tiefe der Kontaktregion der Anschlusskontakte und die Isolationsschicht (21) achsensymmetrisch zu einer Geraden ist, die durch die erste Stromelektrode (2) senkrecht zur Oberfläche der Halbleiterschicht (6) verläuft, oder symmetrisch zu einer ebenen Fläche ist, die durch die erste Stromelektrode (2) senkrecht zur Verbindungsgeraden der Sensorelektroden (4, 5) verläuft.

15. Hallelement nach Anspruch 13 oder 14, dadurch gekennzeichnet, dass die Isolationsschicht (21) aus einem Halbleitermaterial vom entgegengesetzten Leitfähigkeitstyp besteht wie die Halbleiterschicht (6) und einen Anschlusskontakt besitzt zum Anlegen einer elektrischen Spannung ($V_W$), die im Betrieb den P/N-Übergang zwischen der Halbleiterschicht (6) und der Isolationsschicht (21) in Sperrrichtung polt.

16. Hallelement nach Anspruch 15, dadurch gekennzeichnet, dass die an der Isolationsschicht (21) anliegende elektrische Spannung ($V_W$) der Steuerung der Empfindlichkeit des Hallelementes (23, 25) dient.

17. Hallelement nach einem der Ansprüche 1 bis 16, dadurch gekennzeichnet, dass das Material der Halbleiterschicht (6) GaAs ist.

18. Hallelement nach Anspruch 13 oder 14, dadurch gekennzeichnet, dass die Isolationsschicht (21) aus $SiO_2$ besteht.

19. Hallelement nach einem der Ansprüche 1 bis 18, dadurch gekennzeichnet, dass die Halbleiterschicht (6) eine Wanne ist, die in ein Substrat eindiffundiert ist, oder eine Epitaxieschicht ist, die auf einem Substrat (26) aufgewachsen ist, wobei das Substrat vom entgegengesetzten Leitfähigkeitstyp ist wie die Halbleiterschicht (6).

20. Hallelement nach einem der Ansprüche 1 bis 19, dadurch gekennzeichnet, dass mindestens ein Teil der Anschlusskontakte rein ohmisch ist, derart dass unterhalb der an der Oberfläche des Hallelementes gelegenen metallischen Anschlusskontakte (8, 9, 10, 11, 12) und in einem intimen Kontakt mit denselben je ein stark mit Fremdatomen dotierter Diffusions-Kontakt (13, 15, 20, 16, 14) vorhanden ist, der vom gleichen Leitfähigkeitstyp ist wie das Halbleitermaterial, in das er eindiffundiert ist.

21. Hallelement nach einem der Ansprüche 1 bis 20, dadurch gekennzeichnet, dass die Anschlusskontakte der Sensorelektroden (4, 5) als P/N-Dioden ausgebildet sind.

22. Hallelement nach einem der Ansprüche 1 bis 21, dadurch gekennzeichnet, dass ein Teil der Anschlusskontakte als Schottky-Dioden ausgebildet ist.

23. Hallelement nach einem der Ansprüche 1 bis 22, dadurch gekennzeichnet, dass seine Oberfläche mit Ausnahme von Durchführungen für die Anschlusskontakte (19) vollständig mit einem elektrisch gut leitenden und einen Anschlusskontakt aufweisenden "Gate" (18) bedeckt ist, das von der Halbleiterschicht (6) nur durch eine dünne elektrisch isolierende Passivationsschicht (17) getrennt ist.

24. Hallelement nach Anspruch 23, dadurch gekennzeichnet, dass an dem Anschlusskontakt (19) des "Gate" (18) eine elektrische Spannung liegt, die der Steuerung der Empfindlichkeit des Hallelementes dient.

25. Hallelement nach einem der Ansprüche 1 bis 24, dadurch gekennzeichnet, dass es in einer elektrisch isolierten Insel einer integrierten Schaltung eingebaut ist.

26. Hallelement nach einem der Ansprüche 1 bis 25, dadurch gekennzeichnet, dass es der Messung einer parallel zu seiner Oberfläche wirkenden Magnetfeldkomponente dient.

27. Hallelement nach einem der Ansprüche 1 bis 26, dadurch gekennzeichnet, dass es ein Teil eines Messwerkes eines Elektrizitätszählers ist.

## Claims

1. An integratable Hall element which comprises a semiconductor layer (16) of a single conductivity type, at the surface of which are arranged two sensor electrodes (4, 5) and at least a first one of a plurality of current electrodes (2), wherein the current electrodes serve for connection to a supply source and the first current electrode has a first connection contact which forms a first supply pole, characterised in that the first current electrode (2) is disposed approximately centrally between the sensor electrodes (4, 5) and approximately on the straight line connecting same and divided current electrodes which have a connection contact which forms the second supply pole are so arranged that all currents flowing in operation between the current electrodes (2, 3) form a vectorial current resultant which extends in the vicinity of the first current electrode (2) substantially normal to the surface of the semiconductor layer (6).

2. A Hall element according to claim 1 characterised in that at least a portion of the divided current electrodes is arranged in approximately symmetrical relationship about an axis relative to a straight line which extends through the first current electrode (2) normal to the surface of the semiconductor layer (6).

3. A Hall element according to claim 1 or claim 2 characterised in that at least a portion of the divided current electrodes is arranged approximately symmetrically with respect to a flat surface which extends through the first current electrode (2) normal to the straight line connecting the sensor electrodes (4, 5).

4. A Hall element according to claim 2 characterised in that all remaining divided current electrodes are arranged approximately symmetrically with respect to a flat surface which extends through the first current electrode (2) normal to the straight line connecting the sensor electrodes (4, 5).

5. A Hall element according to claim 2 or claim 3 characterised in that there are at least two divided,

0 148 330

approximately punctiform current electrodes (3a, 3b) which are connected by way of a respective resistor (R1, R2) to a pole of a supply voltage, wherein the resistors (R1, R2) serve to nullify an offset voltage.

6. A Hall element according to one of claims 2 to 5 characterised in that at least a portion of the divided current electrodes forms continuous surface portions which are of good electrical conductivity and which are in turn identical in pairs and which are arranged symmetrically with respect to the respective straight line or the respective flat surface like the divided current electrodes of which they are composed.

7. A Hall element according to claim 6 characterised in that all surface portions are arranged parallel to the surface of the semiconductor layer (6).

8. A Hall element according to claim 7 characterised in that all parallel surface portions lie in one plane.

9. A Hall element according to claim 8 characterised in that all surface portions form a single continuous surface.

10. A Hall element according to claim 9 characterised in that the continuous surface is disposed in the semiconductor layer (6) under the active portion (7) of the Hall element parallel to the top surface thereof and that the connection contact thereof is arranged in electrically insulated relationship outside the active portion (7) at the surface of the semiconductor layer (6) and within the semiconductor layer (6) is connected thereto by way of an electrical ohmic connection.

11. A Hall element according to claim 9 characterised in that the continuous surface is disposed in the form of an equipotential diffusion layer (22) in the plane of the surface of the semiconductor layer (6) and that it annularly surrounds the first current electrode (2) and the sensor electrodes (4, 5), wherein the first current electrode (2) is disposed at least approximately in the centre of the annular area.

12. A Hall element according to one of claims 6 to 11 characterised in that the continuous surface portions which have good electrical conductivity comprise semiconductor material which is heavily doped with impurity atoms and which is of the same conductivity type as the semiconductor layer (6).

13. A Hall element according to one of claims 1 to 12 characterised in that there is provided a deep elongate-annular insulating layer (21) which is diffused into the semiconductor layer (6) at the surface and which surrounds at least the first current electrode (2) and the sensor electrodes (4, 5), wherein the centre thereof is approximately formed by the first current electrode (2), the longitudinal axis thereof extends approximately parallel to the straight line connecting the sensor electrodes (4, 5), the depth thereof is significantly greater than the depth of the contact region of the connection contacts and the insulation layer (21) is symmetrical about an axis relative to a straight line which extends through the first current electrode (2) normal to the surface of the semiconductor layer (6) or the insulation layer is symmetrical with respect to a flat surface which extends through the first current electrode (2) normal to the straight line connecting the sensor electrodes (4, 5).

14. A Hall element according to claim 11 or claim 12 characterised in that there is provided a deep elongate-annular insulation layer (21) which is diffused into the semiconductor layer (6) at the surface and which surrounds at least the first current electrode (2) and the sensor electrodes (4, 5) and in turn is surrounded by a continuous annular surface in the form of an eguipotential diffusion layer (22), wherein the centre thereof is formed approximately by the first current electrode (2), the longitudinal axis thereof extends approximately parallel to the straight line connecting the sensor electrodes (4, 5), the depth of the insulation layer is significantly greater than the depth of the contact region of the connection contacts and the insulation layer (21) is symmetrical about an axis relative to a straight line which extends through the first current electrode (2) normal to the surface of the semiconductor layer (6) or is symmetrical with respect to a flat surface which extends through the first current electrode (2) normal to the straight line connecting the sensor electrodes (4, 5).

15. A Hall element according to claim 13 or claim 14 characterised in that the insulation layer (21) comprises a semiconductor material of the opposite conductivity type to the semiconductor layer (6) and has a connection contact for applying an electrical voltage ($V_W$) which in operation biases the P/N-junction between the semiconductor layer (6) and the insulation layer (21) in the non-conducting direction.

16. A Hall element according to claim 15 characterised in that the electrical voltage ($V_W$) applied to the insulation layer (21) serves to control the sensitivity of the Hall element (23, 25).

17. A Hall element according to one of claims 1 to 16 characterised in that the material of the semiconductor layer (6) is GaAs.

18. A Hall element according to claim 13 or claim 14 characterised in that the insulation layer (21) comprises $SiO_2$.

19. A Hall element according to one of claims 1 to 18 characterised in that the semiconductor layer (6) is a well which is diffused into a substrate or an epitaxial layer which is grown on a substrate (26), wherein the substrate is of opposite conductivity type to the semiconductor layer (6).

20. A Hall element according to one of claims 1 to 19 characterised in that at least a portion of the connection contacts is purely ohmic, such that present beneath the metallic connection contacts (8, 9, 10, 11, 12) applied at the surface of the Hall element and in intimate contact therewith is a respective diffusion contact (13, 15, 20, 16, 14) which is heavily doped with impurity atoms and which is of the same conductivity type as the semiconductor material into which it is diffused.

21. A Hall element according to one of claims 1 to 20 characterised in that the connection oontacts of the sensor electrodes (4, 5) are in the form of P/N-diodes.

22. A Hall element according to one of claims 1 to 21 characterised in that a portion of the connection

10

contacts is formed as Schottky diodes.

23. A Hall element according to one of claims 1 to 22 characterised in that its surface, with the exception of passage means for the connection contacts (19), is completely covered with a gate (18) which is of good electrical conductivity and which has a connection contact and which is separated from the semiconductor layer (6) only by a thin electrically insulating passivation layer (17).

24. A Hall element according to claim 23 characterised in that applied to the connection contact (19) of the gate (18) is an electrical voltage which serves to control the sensitivity of the Hall element.

25. A Hall element according to one of claims 1 to 24 characterised in that it installed in an electrically insulated island of an integrated circuit.

26. A Hall element according to one of claims 1 to 25 characterised in that it serves for measurement of a magnetic field component acting parallel to its surface.

27. A Hall element according to one of claims 1 to 26 characterised in that it is a part of a measuring mechanism of an electricity meter.

## Revendications

1. Elément Hall intégrable, qui se compose d'une couche semi-conductrice (6) d'un seul type de conductivité, sur la surface de laquelle sont disposées deux électrodes de détecteur (4, 5) et au moins une première de plusieurs électrodes de courant (2), les électrodes de courant servant à la connexion avec une source d'alimentation et la première électrode de courant comportant un premier contact de connexion qui forme un premier pôle d'alimentation, caractérisé en ce que la première électrode de courant (2) est située approximativement au milieu entre les électrodes de détecteur (4, 5) et approximativement sur leur droite de liaison, et des électrodes de courant réparties, qui comportent un contact de connexion qui forme le second pôle d'alimentation, sont disposées de telle sorte que tous les courants s'écoulant en service entre des électrodes de courant (2, 3) produisent une résultante vectorielle de courant qui est orientée à proximité de la première électrode de courant (2) sensiblement perpendiculairement à la surface de la couche semi-conductrice (6).

2. Elément Hall selon la revendication 1, caractérisé en ce qu'au moins une partie des électrodes de courant réparties sont disposées approximativement avec symétrie axiale par rapport à une droite qui passe par la première électrode de courant (2) perpendiculairement à la surface de la couche semi-conductrice (6).

3. Elément Hall selon la revendication 1 ou 2, caractérisé en ce qu'au moins une partie des électrodes de courant réparties sont disposées approximativement symétriquement par rapport à une surface plane qui passe par la première électrode de courant (2) perpendiculairement à la droite de liaison des électrodes de détecteur (4, 5).

4. Elément Hall selon la revendication 2, caractérisé en ce que toutes les électrodes de courant réparties restantes sont disposées approximativement symétriquement par rapport à une surface plane qui passe par la première électrode de courant (2) perpendiculairement à une droite de liaison des électrodes de détecteur (4, 5).

5. Elément Hall selon la revendication 2 ou 3, caractérisé en ce qu'il est prévu au moins deux électrodes de courant (3a, 3b) réparties avec une forme approximativement ponctuelle et qui sont chacune reliées par l'intermédiaire d'une résistance (R1, R2) avec un pôle d'une source de tension d'alimentation, les résistances (R1, R2) servant à annuler un décalage de tension.

6. Elément Hall selon une des revendications 2 à 5, caractérisé en ce qu'au moins une partie des électrodes de courant réparties forment des surfaces partielles continues et électriquement bonnes conductrices, qui sont pour leur part disposées par paires de façon identique et également symétriquement par rapport à la droite correspondante ou à la surface plane correspondante comme les électrodes de courant réparties dont elles sont composées.

7. Elément Hall selon la revendication 6, caractérisé en ce que toutes les surfaces partielles sont disposées parallèlement à la surface de la couche semi-conductrice (6).

8. Elément Hall selon la revendication 7, caractérisé en ce que toutes les surfaces partielles parallèles sont situées dans un plan.

9. Elément Hall selon la revendication 8, caractérisé en ce que toutes les surfaces partielles forment une seule surface continue.

10. Elément Hall selon la revendication 9, caractérisé en ce que la surface continue est située dans la couche semi-conductrice (6) en dessous de la partie active (7) de l'élément Hall et parallèlement à sa surface, et en ce que son contact de connexion est disposé de façon électriquement isolée à l'extérieur de la partie active (7) sur la surface de la couche semi-conductrice (6) et est reliée, à l'intérieur de la couche semi-conductrice (6), avec elle, par l'intermédiaire d'une liaison ohmique électrique.

11. Elément Hall selon la revendication 9, caractérisé en ce que la surface continue se présentant sous la forme d'une couche de diffusion équipotentielle (22) est placée dans le plan surfacique de la couche semiconductrice (6) et en ce qu'elle enveloppe avec une forme annulaire la première électrode de courant (2) et les électrodes de détecteur (4, 5), la première électrode de courant (2) étant placée au moins approximativement au centre de la surface de forme annulaire.

12. Elément Hall selon une des revendication 6 à 11, caractérisé en ce que les surfaces partielles continues et électriquement conductrices sont formées d'une matière semiconductrice qui est fortement dopée en impuretées et qui a le même type de conductivité que la couche semi-conductrice (6).

13. Elément Hall selon une des revendications 1 à 12, caractérisé en ce qu'il est prévu une couche isolante (21) de forme annulaire allongée qui a pénétré profondément par diffusion dans la surface de la couche semi-conductrice (6) et qui entoure au moins la première électrode de courant (2) et les électrodes de détecteur (4, 5), son centre étant situé à proximité de la première électrode de courant (2), son axe longitudinal étant orienté approximativement parallèlement à la droite de liaison des électrodes de détecteur (4, 5), sa profondeur étant bien plus grande que la profondeur de la région de contact des contacts de connexion, et la couche isolante (21) étant disposée avec symétrie axiale par rapport à une droite qui passe par la première électrode de courant (2) perpendiculairement à la surface de la couche semi-conductrice (6), ou bien la couche isolante est symétrique par rapport à une surface plane qui passe par la première électrode de courant (2) perpendiculairement à la droite de liaison des électrodes de detecteur (4, 5).

14. Elément Hall selon la revendication 11 ou 12, caractérisé en ce qu'il est prévu une couche isolante (21) de forme annulaire allongée, ayant pénétré profondément par diffusion dans la surface de la couche semi-conductrice (6), qui entoure au moins la première électrode de courant (2) et les électrodes de détecteur (4, 5) et qui est elle-même entourée par une surface continue de forme annulaire se présentant sous la forme d'une couche de diffusion équipotentielle (22), son centre étant formé à proximité de la première électrode de courant (2), son axe longitudinal étant orienté approximativement parallèlement à la droite de liaison des électrodes de détecteur (4, 5), la profondeur de la couche isolante étant bien plus grande que la profondeur de la région de contact des contacts de connexion, et la couche isolante (21) ayant une symétrie axiale par rapport à une droite qui passe par la première électrode de courant (2) perpendiculairement à la surface de la couche semi-conductrice (6) ou bien qui est symétrique par rapport à une surface plane qui passe par la première électrode de courant (2) perpendiculairement à la droite de liaison des électrodes de détecteur (4, 5).

15. Elément Hall selon la revendication 13 ou 14, caractérisé en ce que la couche isolante (21) se compose d'une matière semi-conductrice d'un type de conductivité opposé à la couche semi-conductrice (6) et comporte un contact de connexion pour appliquer une tension électrique ($V_W$), qui polarise en service dans le sens de blocage la transition P/N entre la couche semi-conductrice (6) et la couche isolante (21).

16. Elément Hall selon la revendication 15, caractérisé en ce que la tension électrique ($V_W$) appliquée à la couche isolante (21) sert à la commande de sensibilité de l'élément Hall (23, 25).

17. Elément Hall selon une des revendications 1 à 16, caractérisé en ce que la matière de la couche semi-conductrice (6) est du GaAs.

18. Elément Hall selon la revendication 13 ou 14, caractérisé en ce que la couche isolante (21) est formée de $SiO_2$.

19. Elément Hall selon une des revendications 1 à 18, caractérisé en ce que la couche semi-conductrice (6) est un réceptacle qui est formé par diffusion dans un substrat ou bien elle constitue une couche épitaxiale qui a été formée par croissance sur un substrat (26), le substrat ayant une conductivité d'un type opposé à la couche semi-conductrice (6).

20. Elément Hall selon une des revendications 1 à 19, caractérisé en ce qu'au moins une partie des contacts de connexion sont purement ohmiques de telle sorte que, en dessous des contacts métalliques de connexion (8, 9, 10, 11, 12) placés sur la surface de l'élément Hall, il soit prévu en contact intime avec eux respectivement un contact de diffusion fortement dopé en impuretés (13, 15, 20, 16, 14), qui est du même type de conductivité que la matière semi-conductrice dans laquelle il a pénétré par diffusion.

21. Elément Hall selon une des revendications 1 à 20, caractérisé en ce que les contacts de connexion des électrodes de détecteur (4, 5) sont agencés comme des diodes P/N.

22. Elément Hall selon une des revendications 1 à 21, caractérisé en ce qu'une partie des contacts de connexion sont agencés comme des diodes Schottky.

23. Elément Hall selon une des revendications 1 à 22, caractérisé en ce que sa surface, à l'exception de traversées pour les contacts de connexion (19), est complètement recouverte d'une "grille" (18) électriquement bonne conductrice, comportant un contact de connexion, et qui est séparée de la couche semi-conductrice (6) seulement par une couche de passivation (17) mince et électriquement isolante.

24. Elément Hall selon la revendication 23, caractérisé en ce qu'aux contacts de connexion (19) de la "grille" 18 est appliquée une tension électrique qui sert à la commande de sensibilité de l'élément Hall.

25. Elément Hall selon une des revendications 1 à 24, caractérisé en ce qu'il est incorporé dans un flot électriquement isolé d'un circuit intégré.

26. Elément Hall selon une des revendications 1 à 25, caractérisé en ce qu'il sert à la mesure d'une composante de champ magnétique agissant parallèlement à sa surface.

27. Elément Hall selon une des revendications 1 à 26, caractérisé en ce qu'il fait partie d'un dispositif de mesure d'un compteur d'électricité.

Fig. 1

Fig. 2

Fig. 3

# Fig. 4

# Fig. 5

# Fig. 6

# Fig. 8

# Fig. 7

# Fig. 9

# Fig. 10

# Fig. 11

# Fig. 12

# Fig. 13

# Fig. 14

# Fig. 15

# Fig. 16

# Fig. 17

# Fig. 18

# Fig. 19

# Fig. 20

# Fig. 21

V_SS

S1  S2  V_W

V_DD

R1  24  W

R

H  C'2  C1  C"2  R2

3a  4  2  5  3b  21  22

23

# Fig. 22

C'2  S1  C1  S2  C"2  W  21

H

8  3a  9  10  11  12  3b

4  2  5

$N^+$ 13  $N^+$ 15  $N^+$ 20 $N^+$ 16  14  $N^+$

$P^+$  N  N  N  $P^+$

25

7

6  $N^+$  27

P

26

# Fig. 23

4  2  5

21  21

27

# Fig. 24

2

4  5

21

27

9